# FASCICULE DE BREVET EUROPEEN

(11) **EP 1 881 538 B1**
(45) Date de publication et mention de la délivrance du brevet: **24.06.2009**
(21) Numéro de dépôt: 07354044.5
(22) Date de dépôt: 10.07.2007
(51) Int. Cl.: H01L 35/30, H01L 23/427

(54) **Composant électronique à transfert de chaleur par ébullition et condensation et procédé de fabrication**
Elektronisches Bauelement für Wärmetransport durch Verdampfen und Kondensation, sowie Verfahren zur Herstellung.
Electronic component for heat transfer by boiling and condensation, and manufacturing method

(30) Priorité: 20.07.2006 FR 0606615
(43) Date de publication de la demande: 23.01.2008
(73) Titulaire: COMMISSARIAT A L'ENERGIE ATOMIQUE, 75015 Paris (FR)
(72) Inventeur: Gruss, Jean-Antoine, 38170 Seyssinet-Pariset (FR); Plissonnier, Marc, 38320 Eybens (FR)
(74) Mandataire: Jouvray, Marie-Andrée

(56) Documents cités:
- WO-A-20/07019558
- US-A1- 2002 175 408
- US-A1- 2005 006 754
- US-A1- 2005 126 766
- US-A1- 2006 090 885
- US-B1- 6 880 346
- ABRAMSON A R ET AL: "Fabrication and Characterization of a Nanowire/Polymer-Based Nanocomposite for a Prototype Thermoelectric Device" JOURNAL OF MICROELECTROMECHANICAL SYSTEMS, IEEE SERVICE CENTER, PISCATAWAY, NJ, US, vol. 13, no. 3, juin 2004 (2004-06), pages 505-513, XP011113573 ISSN: 1057-7157
- HONDA H ET AL: "Enhanced boiling heat transfer from electronic components by use of surface microstructures" EXPERIMENTAL THERMAL FLUID SCIENCE, vol. 28, 2004, pages 159-169, XP002431993 Elsevier
- RIFFAT S B ET AL: "Improving the coefficient of performance of thermoelectric cooling systems: a review" INTERNATIONAL JOURNAL OF ENERGY RESEARCH WILEY UK, vol. 28, no. 9, juillet 2004 (2004-07), pages 753-768, XP002431994 ISSN: 0363-907X

## Description

### Domaine technique de l'invention

L'invention concerne un composant électronique à transfert de chaleur par ébullition et condensation, comportant des surfaces d'échange de chaleur immergées dans un liquide caloporteur, ainsi qu'un procédé de fabrication d'un tel composant.

### État de la technique

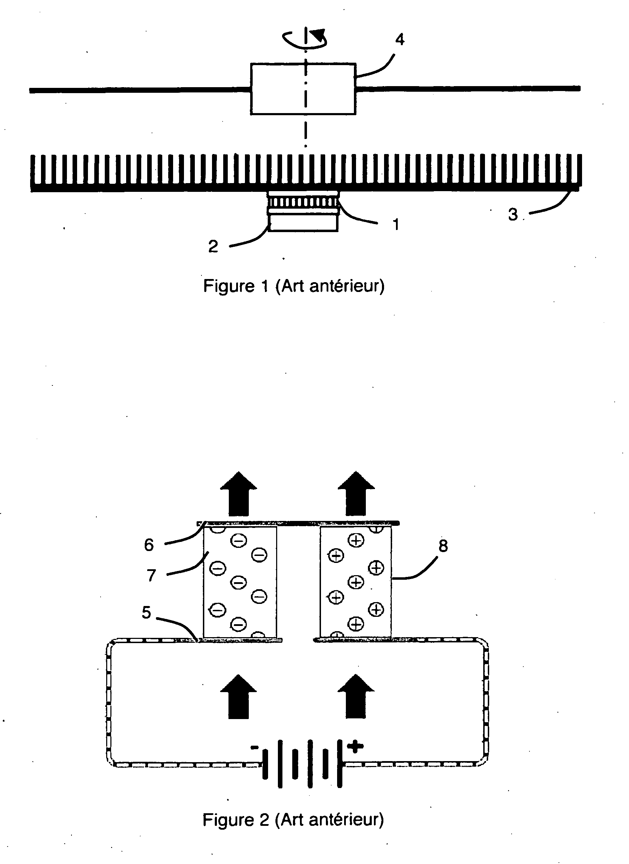

Comme représenté à la figure 1, un dispositif de refroidissement peut être constitué par un composant électronique, par exemple un convertisseur thermoélectrique 1, disposé sur un composant à refroidir constituant une source de chaleur 2 et associé à un refroidisseur à ailettes 3, éventuellement en convection forcée à l'aide d'un ventilateur 4.

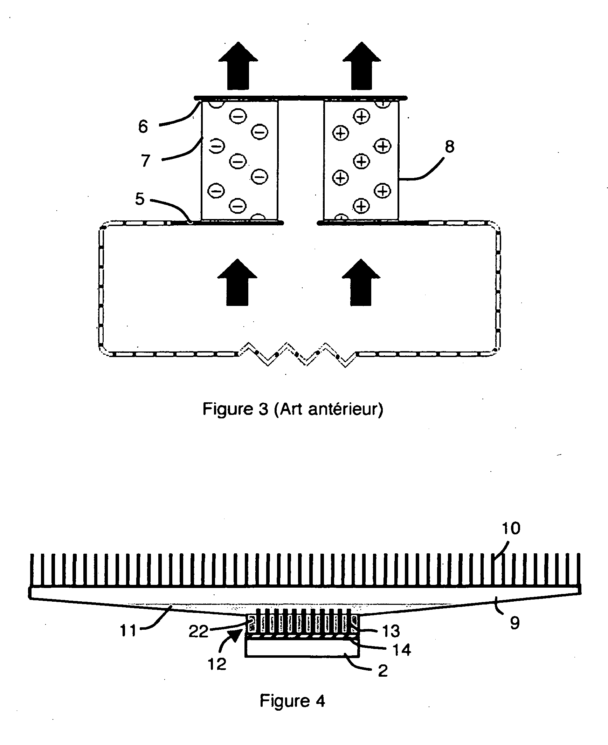

Les composants électroniques utilisés comme convertisseurs thermoélectriques sont classiquement (figures 2 et 3) constitués par des thermocouples connectés thermiquement en parallèle entre des sources 5 et 6 respectivement chaude et froide, chaque thermocouple étant constitué par deux branches 7 et 8, en matériaux métalliques ou semi-conducteurs de nature différente (par exemple respectivement de type n et p), connectées électriquement en série. Le flux thermique traversant le convertisseur thermoélectrique est représenté par des flèches verticales sur les figures 2 et 3.

Un tel convertisseur peut être utilisé pour créer un gradient thermique, par effet Peltier, et ainsi créer un effet de réfrigération thermoélectrique, lorsque les branches sont parcourues par un courant, comme représenté à la figure 2. Réciproquement, il peut être utilisé pour générer un courant électrique, par effet Seebeck, lorsqu'il est soumis à un gradient thermique entre les sources chaude et froide, comme représenté à la figure 3.

Le problème de couplage thermique se pose de la même façon dans un convertisseur thermoélectrique à effet Seebeck, dans lequel la chaleur doit être évacuée au niveau de la source froide pour maintenir le gradient thermique générant le courant électrique, que dans un convertisseur thermoélectrique à effet Peltier, dans lequel la chaleur est rejetée au niveau de la source froide. En effet, dans les deux cas la même résistance thermique entre le convertisseur et la source froide, en général l'air ambiant, limite la quantité de chaleur à évacuer.

Il a été proposé d'utiliser des nanofils pour améliorer le rendement de convertisseurs thermoélectriques en utilisant les phénomènes de confinement quantique, notamment dans la demande de brevet US2002/0175408 et dans l'article "Fabrication and Characterization of a Nanowire/Polymer-Based Nanocomposite for a Prototype Thermoelectric Device", de Alexis R. Abramson et al., dans "Journal of Microelectromechanical Systems", pages 505-513, vol.13, n°3, juin 2004. Dans ces documents, les nanofils sont noyés dans des matrices en polymère, par exemple en parylène dans l'article, pour former des paquets de nanofils ayant tous la même composition, par exemple des semi-conducteurs de type n ou p, dans un même paquet. Les nanofils de même nature sont ensuite connectés électriquement en parallèle à l'intérieur de chaque paquet et au moins deux paquets de nature différente sont interconnectés pour former un convertisseur thermoélectrique.

Par ailleurs, l'utilisation de caloducs ("heat pipe" en anglais) permet d'améliorer d'un facteur 100 à 1000 la conductivité thermique équivalente obtenue au moyen d'une plaque pleine en cuivre et d'obtenir des performances très supérieures à celles d'une plaque à ailettes. Un caloduc se présente classiquement sous la forme d'une enceinte hermétique qui renferme un liquide en équilibre avec sa phase vapeur, en absence de tout autre gaz. Le transfert de chaleur s'effectue de manière passive, par des cycles d'évaporation du liquide sur une partie chaude et de condensation sur une partie froide, par exemple sur une surface du caloduc recouverte extérieurement par des ailettes.

Les caloducs sont actuellement utilisés soit sous forme de refroidisseurs à caloducs rapportés, soit sous forme de chambre caloduc. Cette dernière configuration présente moins de pièces et moins d'assemblages que les refroidisseurs à caloducs rapportés et minimise la résistance thermique, notamment aux interfaces caloducs/plaques et ailettes.

L'article "Enhanced boiling heat transfer from electronic components by use of surface microstructures", de Honda H et Wei JJ, Experimental Thermal and Fluid Science, 28 (2004), p.159-1659, fait une revue de différents travaux concernant l'amélioration, par l'utilisation de microstructures superficielles, des coefficients de transfert de chaleur par ébullition pour des composants électroniques immergés dans des liquides diélectriques. Cet article décrit différentes méthodes de structuration de surfaces, telles que la création de rugosités de surface par sablage, attaque chimique, dépôts poreux, création de cavités réentrantes ou de micro-piliers par des techniques de gravure sèche classiquement employées en micro-électronique.

### Objet de l'invention

L'invention a pour but d'améliorer l'efficacité d'un composant électronique à transfert de chaleur par ébullition et condensation.

Ce but est atteint par un composant selon les revendications annexées et plus particulièrement par le fait que les surfaces d'échange du composant sont constituées par des extrémités libres de nanofils d'un convertisseur thermoélectrique comportant une pluralité de nanofils formés sur un substrat de base, un matériau d'enrobage, électriquement isolant et peu conducteur thermiquement, enrobant partiellement les nanofils étant disposé entre le substrat de base et le liquide caloporteur, chaque nanofil formant un thermocouple constitué de deux branches coaxiales en matériaux de nature différente, séparées par une couche en matériau électriquement isolant et connectées électriquement individuellement à l'extrémité libre du nanofil.

L'invention a également pour objet un procédé de fabrication d'un tel composant.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre schématiquement un dispositif de refroidissement selon l'art antérieur.
Les figures 2 et 3 illustrent schématiquement l'utilisation d'un convertisseur thermoélectrique selon l'art antérieur respectivement comme dispositif de réfrigération et comme générateur électrique.
Les figures 4 et 5 illustrent deux variantes de réalisation d'un composant selon l'invention.
Les figures 6 et 7 représentent un détail de la partie inférieure de deux modes particuliers de réalisation d'un composant selon l'invention.
Les figures 8 à 10 représentent des étapes successives d'un mode particulier de réalisation d'un procédé de fabrication selon l'invention.
Les figures 11 à 14 représentent des variantes de réalisation du procédé selon l'invention.

### Description de modes de réalisation particuliers de l'invention

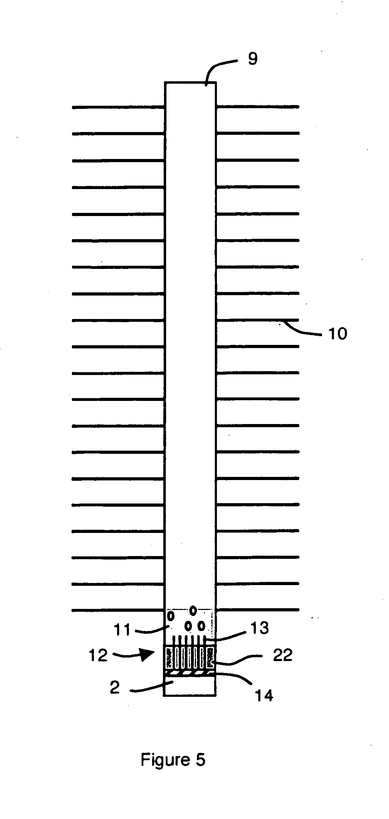

Dans les deux variantes de réalisation de l'invention représentées aux figures 4 et 5, le transfert de chaleur entre le composant 2 à refroidir et l'air ambiant est réalisé par l'intermédiaire d'un caloduc 9, c'est-à-dire par l'intermédiaire d'un transfert de chaleur par ébullition et condensation fonctionnant en circuit fermé, avec retour de liquide soit par gravité soit par capillarité. Le caloduc peut avoir toute configuration connue appropriée.

À titre d'exemple, le caloduc 9 de la figure 4 a la forme d'une chambre évasée vers le haut présentant, de préférence, des ailettes 10 sur la face externe de sa paroi supérieure. Le caloduc 9 de la figure 5 est, quant à lui, constitué par un tube cylindrique vertical comportant, de préférence, des ailettes 10 sur la face externe de sa paroi latérale.

Sur les figures 4 et 5, le composant 2 à refroidir constitue la source chaude d'un convertisseur thermoélectrique à nanofils, comportant une pluralité de nanofils 13 formés sur un substrat de base 14. Les extrémités libres des nanofils rejettent la chaleur vers la source froide, constituée par l'air ambiant. Cependant, le couplage thermique de convertisseurs thermoélectriques à base de nanofils par contact entre l'extrémité des nanofils et une plaque de refroidissement ou la surface inférieure d'un caloduc est problématique, notamment en raison de la fragilité des nanofils, de la résistance thermique de contact et de la connectique électrique.

Sur les figures 4 et 5, les extrémités libres des nanofils 13 sont utilisées comme surfaces d'échange de chaleur immergées dans le liquide caloporteur 11 du caloduc 9. Les nanofils remplissent ainsi à la fois leur fonction de générateur thermoélectrique et une fonction de surface d'échange thermique améliorée. Cependant, les convertisseurs thermoélectriques à nanofils connus ne permettent pas cette double fonction, notamment du fait que les nanofils adjacents du convertisseur, sont connectés électriquement en série alternativement au niveau de la source chaude (à leur base) et au niveau de la source froide (à leur partie supérieure), deux nanofils parallèles adjacents, de nature différente, constituant ainsi un thermocouple.

Pour permettre cette double fonction, chaque nanofil forme un thermocouple constitué de deux branches coaxiales en matériaux de nature différente, séparées par une couche en matériau électriquement isolant et connectées électriquement individuellement à l'extrémité libre du nanofil.

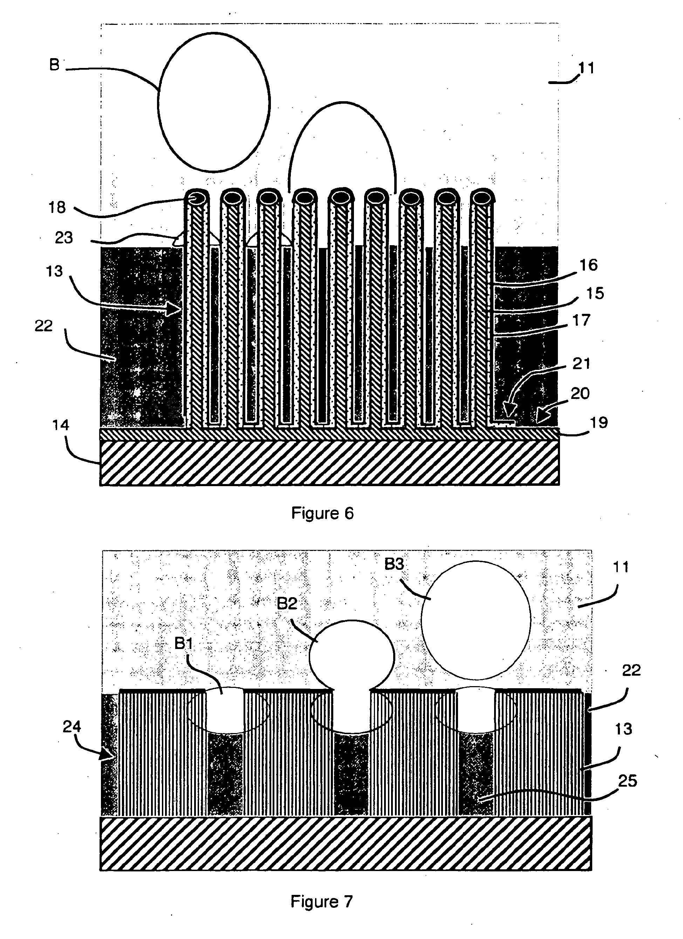

Comme représenté plus en détail à la figure 6, chaque nanofil 13 du convertisseur 12 est ainsi constitué par une âme 15 recouverte à sa périphérie par une couche en matériau isolant 16 et par une enveloppe 17. L'âme 15 et l'enveloppe 17 d'un nanofil 13 sont constituées par des matériaux métalliques différents ou par des matériaux semi-conducteurs de type différent (par exemple respectivement de type n et p) et connectées électriquement à l'extrémité libre du nanofil 13, qui constitue ainsi un thermocouple dont l'âme constitue une première branche, centrale, et dont l'enveloppe constitue la seconde branche, périphérique.

Un tel convertisseur est, de préférence, réalisé en utilisant un procédé de fabrication d'un nanofil par croissance de type VLS (voir US-A-2002/0175408 et l'article précité de A. R. Abramson). Ce type de croissance implique l'utilisation d'un catalyseur métallique et pendant toute la phase de croissance du nanofil, une gouttelette de catalyseur, par exemple en or, est disposée au sommet du nanofil.

Les âmes 15 des nanofils sont alors réalisées sur le substrat de base 14, par croissance de type vapeur-liquide-solide. L'âme de chaque nanofil, de préférence en matériau semi-conducteur dopé d'un premier type, est, à la fin de l'étape de croissance, surmontée par une gouttelette 18 en matériau électriquement conducteur ayant servi de catalyseur pendant l'étape de croissance. Cette gouttelette 18 peut être conservée et utilisée pour connecter automatiquement, électriquement et individuellement, les deux branches du nanofil correspondant.

Après cette étape de croissance, la couche 16 en matériau électriquement isolant est formée autour de l'âme 15 de chaque nanofil, par exemple par oxydation de cette âme à sa périphérie. La couche 16 ne recouvre pas les gouttelettes 18. Puis, l'enveloppe 17, de préférence en matériau semi-conducteur dopé d'un second type, est formée, de manière à compléter chaque nanofil, de préférence en recouvrant la couche en matériau isolant 16 et la gouttelette associée au nanofil. Cette gouttelette 18 interconnecte alors individuellement l'âme et l'enveloppe coaxiales du nanofil correspondant.

Dans le mode de réalisation particulier de la figure 6, les âmes 15, en semi-conducteur de type n, d'un réseau de nanofils sont formées simultanément par croissance VLS sur une couche de même nature (semi-conducteur dopé n), formée sur le substrat 14. Deux âmes 15 adjacentes sont alors connectées électriquement par cette couche, qui constitue une base 19 sensiblement perpendiculaire au réseau de nanofils 13.

La couche isolante 16 recouvre alors non seulement la périphérie des âmes 15, mais également la base 19, au moins entre deux âmes 15 adjacentes. La couche en matériau semi-conducteur de type p recouvre alors la totalité de la couche isolante 16, aussi bien autour qu'entre les âmes 15, ainsi que toutes les gouttelettes 18 associées.

Ce procédé de fabrication permet ainsi de former collectivement, par exemple par croissance de type VLS, un réseau de nanofils 13 constituant des thermocouples connectés électriquement en parallèle et constitués chacun par la connexion en série d'une âme 15, de la gouttelette 18 correspondante et de l'enveloppe 17 associée.

Chaque réseau de nanofils peut comporter deux bornes de connexion. Une première borne de connexion 20 peut être constituée par une zone de la base 19 en saillie d'un côté du réseau (sur la droite sur la figure 6) et non recouverte par la couche isolante 10. La seconde borne de connexion 21 peut être constituée par une zone latérale de l'enveloppe 17, soit du même côté que la borne 20 (également à droite, comme sur la figure 6), soit du côté opposé (sur la gauche), soit sur un côté perpendiculaire. Les connexions électriques du réseau de nanofils avec d'autres réseaux de nanofils ou avec l'extérieur sont ainsi reportées sensiblement au niveau du substrat 14, par exemple d'un même côté, de part et d'autre, ou sur des côtés perpendiculaires du convertisseur.

Pour former un convertisseur thermoélectrique, des réseaux de nanofils adjacents peuvent être connectés électriquement en série, en utilisant les techniques classiques en microélectronique.

Les extrémités libres des nanofils 13 du convertisseur ainsi formé sont, comme indiqué plus haut, immergées dans le liquide caloporteur 11 d'un caloduc 9. Comme représenté sur les figures 4 à 6, un matériau d'enrobage 22, électriquement isolant et peu conducteur thermiquement, enrobant partiellement les nanofils est disposé entre le substrat de base 18 et le liquide caloporteur 11. Ce matériau d'enrobage 22, qui imprègne la base des nanofils 13, est, de préférence, constitué par un polymère, par exemple par du parylène. Il réalise une isolation hydraulique et thermique, le liquide caloporteur ne pouvant atteindre que l'extrémité supérieure, libre, des nanofils. Les bornes de connexion électrique 20 et 21, toutes disposées au niveau du substrat de base 14, sont isolées du fluide caloporteur par le matériau d'enrobage.

Les protubérances formées par les extrémités libres des nanofils constituent des surfaces d'échange de chaleur immergées dans le liquide caloporteur particulièrement avantageuses pour minimiser la résistance thermique entre leur surface et la vapeur du caloduc. Comme illustré à la figure 6, de très nombreux sites de nucléation 23 sont ainsi créés par piégeage de micro-bulles ou de nano-bulles de gaz sur la surface du matériau d'enrobage, plus particulièrement à l'interface entre le matériau d'enrobage 22, le liquide caloporteur 11 et les nanofils 13. En effet, l'apparition de ces micro-bulles ou nano-bulles est favorisée par la variation des propriétés de mouillage à l'interface entre les nanofils, plutôt hydrophiles, et le polymère, plutôt hydrophobe. Par ailleurs, l'augmentation de la surface chaude d'échange (constituée par les extrémités libres des nanofils) dans les bulles de vapeur permet une croissance plus rapide des bulles et, en conséquence, un meilleur coefficient d'échange.

La très faible inertie thermique de nanofils est également avantageuse. En effet, l'ébullition du liquide caloporteur dans le caloduc créant des fluctuations rapides de température sur la surface chaude avec des pseudo-périodes allant de quelques dizaines à quelques centaines de Hertz, cette faible inertie permet de faire fonctionner les branches des thermocouples en régime non stationnaire. En effet, il a été démontré que dans ce régime, les phénomènes de conduction thermique dans les branches des thermocouples sont plus lents que les phénomènes de conduction électrique. Les performances obtenues par les thermocouples sont alors meilleures qu'en régime permanent.

Les deux fonctions des nanofils, à savoir la constitution de thermocouples d'un convertisseur thermoélectrique et le transfert de chaleur par l'intermédiaire d'un caloduc sont ainsi optimisées simultanément.

Dans la variante de réalisation illustrée à la figure 7, les nanofils sont regroupés en paquets 24 adjacents, séparés par des intervalles 25, constituant des micro-cavités ré-entrantes destinées à piéger les micro-bulles. La figure 7 illustre schématiquement, de gauche à droite, la formation d'une bulle B1 dans une cavité ré-entrante 25, la croissance d'une bulle B2 à partir d'une bulle piégée dans une cavité et le détachement d'une bulle B3, qui se sépare de la bulle initialement piégée, qui reste dans la cavité, tandis que la bulle B3 s'élève dans le liquide caloporteur 11. Il est ainsi possible d'améliorer encore les coefficients de transfert de chaleur par ébullition et condensation.

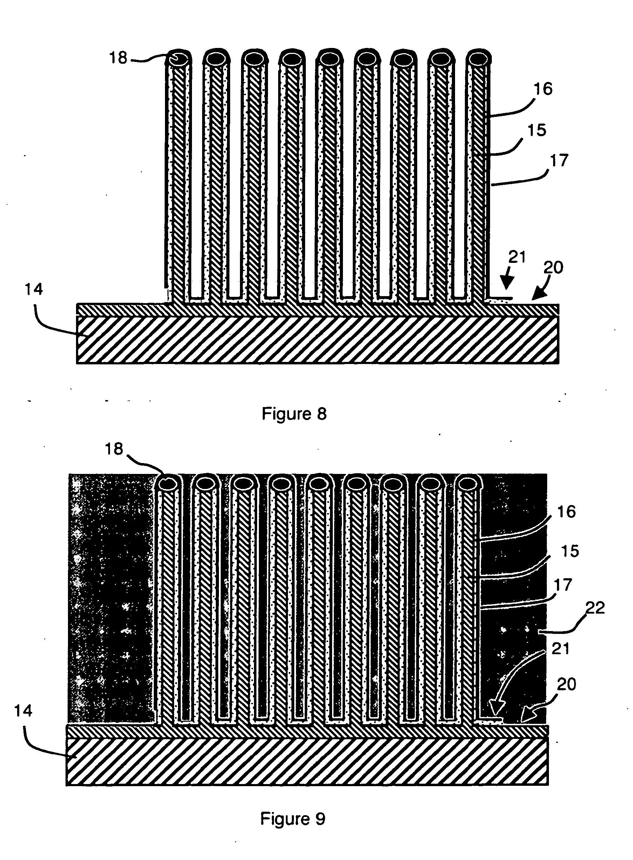

Les étapes successives d'un exemple de réalisation d'un composant sont illustrées aux figures 8 à 10.

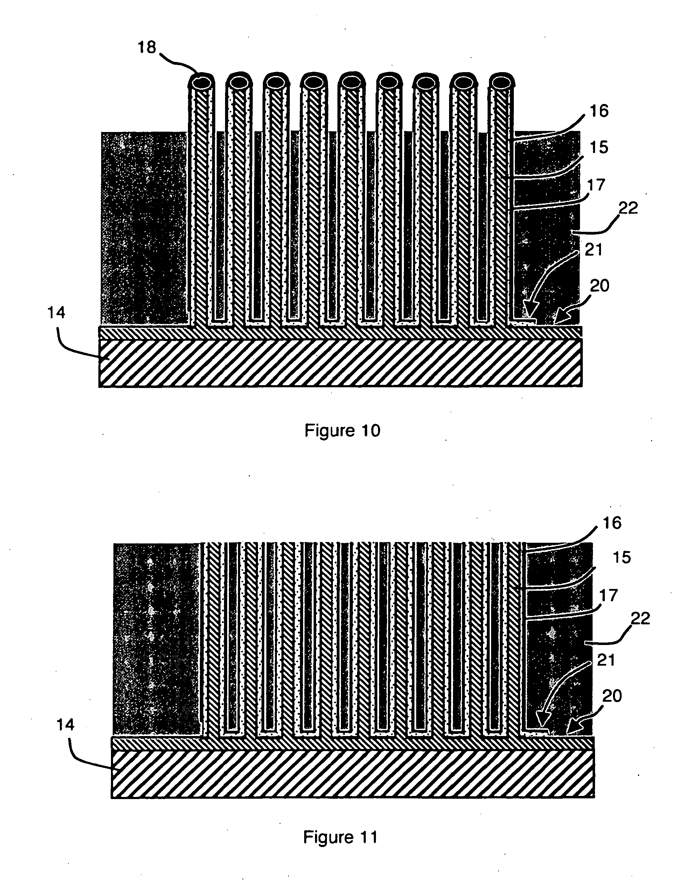

Le convertisseur illustré à la figure 8 est réalisé de la manière décrite ci-dessus en référence à la figure 6. Puis, comme représenté à la figure 9, l'ensemble est imprégné avec un polymère, constituant le matériau d'enrobage 22, sous phase liquide ou vapeur, de préférence avec du parylène sous phase vapeur. Les extrémités supérieures des nanofils 13 sont ensuite libérées, comme représenté à la figure 10, par attaque du polymère sur une certaine profondeur, pour éliminer une épaisseur prédéterminée du matériau d'enrobage. Cette attaque peut être réalisée par toute technique appropriée connue en micro-électronique, par exemple par attaque par plasma ou attaque chimique.

Le composant est ensuite complété, comme représenté sur les figures 4 à 6, par immersion des extrémités libres des nanofils dans le liquide caloporteur 11 d'un caloduc. Le composant peut ensuite être utilisé pour refroidir un composant 2, sur lequel il est disposé. Dans une variante de réalisation, le substrat de base 14 peut être formé directement sur le composant à refroidir.

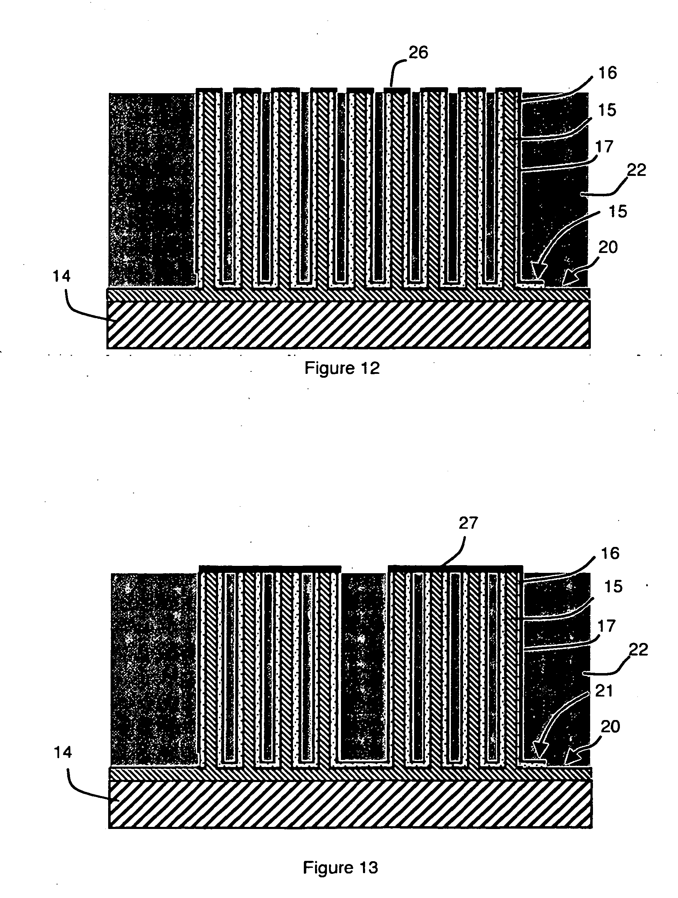

Dans une variante de réalisation illustrée aux figures 11 et 12, le procédé de fabrication reste inchangé jusqu'à la figure 9. Cependant, les gouttelettes 18 ne sont pas conservées pour former les connexions électriques individuelles entre l'âme et l'enveloppe des nanofils. En effet, après imprégnation des nanofils par le polymère (fig.9), une étape de planarisation (fig.11) élimine simultanément la partie supérieure du polymère et les extrémités supérieures des nanofils, mettant à nu, au niveau de la surface libre du polymère, l'âme 15, la couche isolante 16 et l'enveloppe 17 de chaque nanofil. Puis, des jonctions électriques individuelles 26 destinées à connecter individuellement l'âme et l'enveloppe de chaque nanofil sont réalisées par métallisation (fig.12), au niveau de la surface supérieure libre du polymère 22, par toute technique classique de métallisation.

Dans le cas où les nanofils sont regroupés par paquets 24, comme sur la figure 7, pour réaliser des cavités ré-entrantes, les nanofils d'un même paquet sont, de préférence, connectés électriquement en parallèle, tandis que tous les paquets sont connectés en série. Dans la variante de la figure 13, une jonction électrique commune 27, également formée par métallisation, connecte alors, de préférence électriquement toutes les extrémités libres des nanofils d'un paquet, formant ainsi simultanément la jonction électrique entre l'âme et l'enveloppe d'un nanofil et la connexion électrique en parallèle de tous les nanofils d'un paquet.

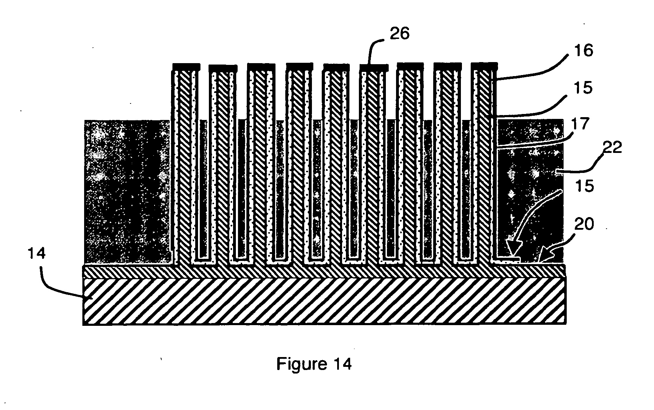

Que les métallisations des nanofils soient individuelles (fig.12) ou communes à un paquet (fig. 13), la fabrication se poursuit, comme sur la figure 10, par élimination d'une épaisseur prédéterminée du matériau d'enrobage pour libérer les extrémités des nanofils à immerger dans le liquide caloporteur du caloduc. Le composant obtenu à l'issue de cette étape dans le cas de métallisations individuelles est illustré à la figure 14.

Les protubérances créées par les nanofils dans le liquide caloporteur, au-dessus du matériau d'enrobage, ont typiquement une hauteur comprise entre 0,01 et 100 micromètres, plus particulièrement de l'ordre de 2 micromètres. Dans la variante regroupant les nanofils par paquets, les paquets 24 peuvent avoir une section carrée ou rectangulaire de 1 à 100 micromètres de côté, plus particulièrement de l'ordre de 10 micromètres, avec un espacement entre paquets du même ordre (compris 1 et 100 micromètres, plus particulièrement de l'ordre de 10 micromètres). Les paquets peuvent avantageusement être répartis régulièrement de manière à former des lignes et des colonnes en vue de dessus.

Le composant décrit ci-dessus peut être utilisé aussi bien dans une configuration utilisant l'effet Peltier pour rejeter de la chaleur vers l'air ambiant, que dans une configuration utilisant l'effet Seebeck pour évacuer de la chaleur vers l'air ambiant.

## Revendications

1. Composant électronique à transfert de chaleur par ébullition et condensation, comportant des surfaces d'échange de chaleur immergées dans un liquide caloporteur (11), composant **caractérisé en ce que** lesdites surfaces sont constituées par des extrémités libres de nanofils (13) d'un convertisseur thermoélectrique comportant une pluralité de nanofils (13) formés sur un substrat de base (14), un matériau d'enrobage (22), électriquement isolant et peu conducteur thermiquement, enrobant partiellement les nanofils (13) étant disposé entre le substrat de base (14) et le liquide caloporteur (11), chaque nanofil (13) formant un thermocouple constitué de deux branches coaxiales en matériaux de nature différente, séparées par une couche (16) en matériau électriquement isolant et connectées électriquement (18, 26) individuellement à l'extrémité libre du nanofil.

2. Composant selon la revendication 1, **caractérisé en ce que** le matériau d'enrobage (22) est un polymère.

3. Composant selon la revendication 2, **caractérisé en ce que** le matériau d'enrobage (22) est du parylène.

4. Composant selon l'une quelconque des revendications 1 à 3, **caractérisé en ce que** les nanofils (13) sont regroupés en paquets adjacents (24) séparés par des intervalles (25) constituant des cavités ré-entrantes, les extrémités libres des nanofils d'un paquet étant connectées électriquement (27) les unes aux autres.

5. Composant selon l'une des revendications 1 à 4, **caractérisé en ce que** l'une des branches de chaque nanofil est constituée par une âme (15) en matériau métallique ou semi-conducteur, recouverte à sa périphérie par la couche (16) en matériau isolant et par une enveloppe (17) en matériau métallique différent ou semi-conducteur de type différent, une jonction électrique en matériau électriquement conducteur (18, 26, 27) connectant individuellement l'âme et l'enveloppe de chaque nanofil à son extrémité libre.

6. Composant selon la revendication 5, **caractérisé en ce que** les âmes (15) de deux nanofils (13) adjacents sont connectés par une couche en matériau semi-conducteur dopé du premier type, constituant une base (19) sensiblement perpendiculaire aux nanofils.

7. Composant selon la revendication 6, **caractérisé en ce que** la couche (16) en matériau isolant recouvre la base (19) entre deux nanofils (13) adjacents, les enveloppes (17) de deux nanofils (13) adjacents étant connectées, au-dessus de la couche (16) en matériau isolant, par une couche en matériau semi-conducteur dopé du second type.

8. Procédé de fabrication d'un composant électronique à transfert de chaleur par ébullition et condensation, **caractérisé en ce qu'**il comporte :
- la formation d'un convertisseur thermoélectrique (1) comportant une pluralité de nanofils (13) sur un substrat de base (14), chaque nanofil (13) formant un thermocouple constitué de deux branches coaxiales en matériaux de nature différente, séparées par une couche (16) en matériau électriquement isolant et connectées électriquement individuellement à l'extrémité libre du nanofil,
- l'imprégnation partielle des nanofils par un matériau d'enrobage (22), isolant électriquement et peu conducteur thermiquement, et
- l'immersion des extrémités libres des nanofils dans un liquide caloporteur (11) d'un caloduc (9).

9. Procédé selon la revendication 8, **caractérisé en ce que** le matériau d'enrobage (22) est un polymère.

10. Procédé selon la revendication 9, **caractérisé en ce que** le matériau d'enrobage (22) est du parylène.

11. Procédé selon l'une quelconque des revendications 8 à 10, **caractérisé en ce que** l'imprégnation partielle des nanofils (13) comporte le dépôt du matériau d'enrobage (22) sous phase liquide ou vapeur et l'élimination d'une épaisseur prédéterminée du matériau d'enrobage pour libérer les extrémités des nanofils.

12. Procédé selon l'une quelconque des revendications 8 à 10, **caractérisé en ce qu'**il comporte successivement le dépôt du matériau d'enrobage (22) sous phase liquide ou vapeur, une étape de planarisation, un dépôt métallique pour former les jonctions électriques (26, 27) entre les branches des nanofils (13) et l'élimination d'une épaisseur prédéterminée du matériau d'enrobage (22) pour libérer les extrémités des nanofils.

13. Procédé selon la revendication 12, **caractérisé en ce que** les nanofils (13) étant regroupés en paquets (24) adjacents séparés par des intervalles (25) constituant des cavités ré-entrantes, le dépôt métallique (27) connecte électriquement toutes les extrémités libres des nanofils (13) d'un paquet (24).

14. Procédé selon l'une quelconque des revendications 8 à 13, **caractérisé en ce que** la formation du convertisseur thermoélectrique (1) comporte successivement une étape de croissance pour former sur le substrat de base (14), par croissance de type vapeur-liquide-solide, des âmes (15) en matériau métallique ou semi-conducteur constituant chacune une des branches d'un des nanofils, la formation de la couche (16) en matériau électriquement isolant recouvrant chaque âme (15) à sa périphérie, puis la formation d'enveloppes (17), en matériau métallique différent ou semi-conducteur de type différent, constituant les autres branches des nanofils, une jonction électrique (18, 26, 27) en matériau électriquement conducteur connectant individuellement l'âme (15) et l'enveloppe (17) de chaque nanofil à son extrémité libre.

15. Procédé selon la revendication 14, **caractérisé en ce que**, l'âme (15) de chaque nanofil étant, à la fin de l'étape de croissance, surmontée par une gouttelette (18) en matériau électriquement conducteur ayant servi de catalyseur pendant l'étape de croissance, ladite gouttelette (18) de catalyseur constitue la jonction électrique entre l'âme et l'enveloppe dudit nanofil.

16. Procédé selon l'une des revendications 8 à 15, **caractérisé en ce que** la couche (16) en matériau électriquement isolant est formée par oxydation des branches qu'elle recouvre à leur périphérie.

## Claims

1. Electronic component with heat transfer by boiling and condensation comprising heat exchange surfaces immersed in a heat conducting fluid (11), component **characterized in that** said surfaces are formed by free ends of nanowires (13) of a thermoelectric converter comprising a plurality of nanowires (13) formed on a base substrate (14), an electrically insulating coating material (22) with low thermal conduction partially coating the nanowires (13) being arranged between the base substrate (14) and the heat conducting fluid (11), each nanowire (13) forming a thermocouple formed by two coaxial branches made from materials of different natures separated by a layer (16) of electrically insulating material and electrically connected (18, 26) individually at the free end of the nanowire.

2. Component according to claim 1, **characterized in that** the coating material (22) is a polymer.

3. Component according to claim 2, **characterized in that** the coating material (22) is parylene.

4. Component according to any one of claims 1 to 3, **characterized in that** the nanowires (13) are grouped in adjacent packets (24) separated by gaps (25) constituting re-entrant cavities, the free ends of the nanowires of a packet being electrically connected (27) to one another.

5. Component according to any one of claims 1 to 4, **characterized in that** one of the branches of each nanowire is formed by a core (15) made of metallic or semi-conducting material covered at its periphery by the layer (16) of insulating material and by an envelope (17) made of different metallic or different type semi-conducting material, an electrical junction made of electrically conducting material (18, 26, 27) individually connecting the core and the envelope of each nanowire at the free end of the latter.

6. Component according to claim 5, **characterized in that** the cores (15) of two adjacent nanowires (13) are connected by a layer of doped semi-conducting material of the first type, constituting a base (19) substantially perpendicular to the nanowires.

7. Component according to claim 6, **characterized in that** the layer (16) of insulating material covers the base (19) between two adjacent nanowires (13), the envelopes (17) of two adjacent nanowires (13) being connected, above the layer (16) of insulating material, by a layer of doped semi-conducting material of the second type.

8. Method for producing an electronic component with heat transfer by boiling and condensation, **characterized in that** it comprises:
- formation of a thermoelectric converter (1) comprising a plurality of nanowires (13) on a base substrate (14), each nanowire (13) forming a thermocouple composed of two coaxial branches made from materials of different natures separated by a layer (16) of electrically insulating material and electrically connected individually at the free end of the nanowire,
- partial impregnation of the nanowires by an electrically insulating coating material (22) with a low thermal conduction, and
- immersion of the free ends of the nanowires in a heat conducting fluid (11) of a heat pipe (9).

9. Method according to claim 8, **characterized in that** the coating material (22) is a polymer.

10. Method according to claim 9, **characterized in that** the coating material (22) is parylene.

11. Method according to any one of claims 8 to 10, **characterized in that** partial impregnation of the nanowires (13) comprises deposition of the coating material (22) in fluid or vapor phase and elimination of a predetermined thickness of the coating material to release the ends of the nanowires.

12. Method according to any one of claims 8 to 10, **characterized in that** it successively comprises deposition of the coating material (22) in fluid or vapor phase, a planarization step, a metallic deposition to form the electrical junctions (26, 27) between the branches of the nanowires (13) and elimination of a predetermined thickness of the coating material (22) to free the ends of the nanowires.

13. Method according to claim 12, **characterized in that**, the nanowires (13) being grouped in adjacent packets (24) separated by gaps (25) constituting re-entrant cavities, the metallic deposition (27) electrically connects all the free ends of the nanowires (13) of a packet (24).

14. Method according to any one of claims 8 to 13, **characterized in that** formation of the thermoelectric converter (1) successively comprises a growth step to form cores (15), by vapor-fluid-solid growth, on the base substrate (14), the cores being made of metallic or semi-conducting material and each constituting one of the branches of one of the nanowires, formation of the layer (16) of electrically insulating material covering each core (15) at the periphery of the latter, then formation of envelopes (17) made of a different metallic or different type semi-conducting material constituting the other branches of the nanowires, an electrical junction (18, 26, 27) made of electrically conducting material individually connecting the core (15) and the envelope (17) of each nanowire at the free end of the latter.

15. Method according to claim 14, **characterized in that**, a droplet (18) of electrically conducting material that acted as catalyst during the growth step remaining on the top of the core (15) of each nanowire at the end of the growth step, said droplet (18) of catalyst constitutes the electrical junction between the core and the envelope of said nanowire.

16. Method according to one of claims 8 to 15, **characterized in that** the layer (16) of electrically insulating material is formed by oxidation of the branches it covers at the periphery of the latter.

## Patentansprüche

1. Elektronisches Bauelement für Wärmetransport durch Verdampfen und Kondensation, das Wärmeaustauschflächen hat, die in eine Wärme leitenden Flüssigkeit (11) getaucht sind, Bauelement, das **dadurch gekennzeichnet ist, dass** die genannten Flächen von freien Enden von Nanodrähten (13) eines thermoelektrischen Wandlers mit einer Mehrzahl von Nanodrähten (13) gebildet werden, die auf einem Grundsubstrat (14) hergestellt sind, wobei ein Beschichtungsmaterial (22), das elektrisch isolierend und thermisch schwach leitend ist und die Nanodrähte (13) teilweise überzieht, zwischen dem Grundsubstrat (14) und der Wärme leitenden Flüssigkeit (11) angeordnet ist und jeder Nanodraht (13) ein Thermoelement bildet, das von zwei koaxialen Armen aus unterschiedlichen Materialien gebildet wird, die durch eine Schicht (16) aus elektrisch isolierendem Material getrennt sind und am freien Ende des Nanodrahts individuell (18, 26) elektrisch miteinander verbunden sind.

2. Bauelement nach Anspruch 1, **dadurch gekennzeichnet, dass** das Beschichtungsmaterial (22) ein Polymer ist.

3. Bauelement nach Anspruch 2, **dadurch gekennzeichnet, dass** das Beschichtungsmaterial (22) Parylene ist.

4. Bauelement nach einem der Ansprüche 1 bis 3, **dadurch gekennzeichnet, dass** die Nanodrähte (13) in angrenzenden Paketen (24) zusammengefasst sind, die durch Zwischenräume (25) getrennt sind, die einziehende Hohlräume bilden, wobei die freien Enden der Nanodrähte eines Pakets elektrisch miteinander verbunden (27) sind.

5. Bauelement nach einem der Ansprüche 1 bis 4, **dadurch gekennzeichnet, dass** einer der Arme jedes Nanodrahts von einer Seele (15) aus Metall oder halbleitendem Material gebildet wird, die an ihrem Umfang von der Schicht (16) aus isolierendem Material und von einer Hülle (17) aus einem anderen Metall oder einem anderen halbleitenden Material bedeckt ist, wobei eine elektrische Verbindung aus elektrisch leitendem Material (18, 26, 27) die Seele und die Hülle jedes Nanodrahts an seinem freien Ende individuell miteinander verbindet.

6. Bauelement nach Anspruch 5, **dadurch gekennzeichnet, dass** die Seelen (15) zweier angrenzender Nanodrähte (13) mittels einer Schicht aus halbleitendem, dotierten Material der ersten Art miteinander verbunden sind, das eine zu den Nanodrähten im Wesentlichen lotrechte Basis (19) bildet.

7. Bauelement nach Anspruch 6, **dadurch gekennzeichnet, dass** die Schicht (16) aus isolierendem Material die Basis (19) zwischen zwei angrenzenden Nanodrähten (13) bedeckt, wobei die Hüllen (17) zweier angrenzender Nanodrähte (13) über der Schicht (16) aus isolierendem Material durch eine Schicht aus halbleitendem, dotiertem Material der zweiten Art verbunden sind.

8. Verfahren zur Herstellung eines elektronischen Bauteils für Wärmetransport durch Verdampfen und Kondensation, **dadurch gekennzeichnet, dass** es umfasst:
- die Herstellung eines thermoelektrischen Wandlers (1), der eine Mehrzahl von Nanodrähten (13) auf einem Grundsubstrat (14) umfasst, wobei jeder Nanodraht (13) ein Thermoelement bildet, das aus zwei koaxialen Armen aus unterschiedlichen Materialien besteht, die durch eine Schicht (16) aus elektrisch isolierendem Material getrennt und am freien Ende des Nanodrahts individuell miteinander verbunden sind,
- partielle Durchtränkung der Nanodrähte mit einem Beschichtungsmaterial (22), das elektrisch isolierend und thermisch schwach leitend ist, und
- Eintauchen der freien Enden der Nanodrähte in eine Wärme leitende Flüssigkeit (11) eines Wärmeleitrohrs (9).

9. Verfahren nach Anspruch 8, **dadurch gekennzeichnet, dass** das Beschichtungsmaterial (22) ein Polymer ist.

10. Verfahren nach Anspruch 9, **dadurch gekennzeichnet, dass** das Beschichtungsmaterial (22) Parylene ist.

11. Verfahren nach einem der Ansprüche 8 bis 10, **dadurch gekennzeichnet, dass** die partielle Imprägnierung der Nanodrähte (13) das Aufdampfen oder Auftragen des Beschichtungsmaterials (22) in Flüssigphase und das Wegnehmen einer vorbestimmten Dicke des Beschichtungsmaterials zum Freilegen der Enden der Nanodrähte umfasst.

12. Verfahren nach einem der Ansprüche 8 bis 10, **dadurch gekennzeichnet, dass** es nacheinander das Aufdampfen oder Auftragen des Beschichtungsmaterials (22) in Flüssigphase, einen Planarisierungsschritt, einen Metallauftrag zur Herstellung der elektrischen Verbindungen (26, 27) zwischen den Armen der Nanodrähte (13) und das Wegnehmen einer vorbestimmten Dicke des Beschichtungsmaterials (22) zum Freilegen der Enden der Nanodrähte umfasst.

13. Verfahren nach Anspruch 12, **dadurch gekennzeichnet, dass**, die Nanodrähte (13) in angrenzenden Paketen (24) zusammengefasst sind, die durch Zwischenräume (25) getrennt sind, die einziehende Hohlräume bilden, wobei der Metallauftrag (27) alle freien Enden der Nanodrähte (13) eines Pakets (24) elektrisch miteinander verbindet.

14. Verfahren nach einem der Ansprüche 8 bis 13, **dadurch gekennzeichnet, dass** die Herstellung des thermoelektrischen Wandlers (1) nacheinander umfasst : einen Wachstumsschritt zur Herstellung des Grundsubstrats (14) durch dampf-flüssig-fest Aufwachsen, wobei Seelen (15) aus Metall oder halbleitendem Material jeweils einen der Arme eines der Nanodrähte bilden, die Herstellung der Schicht (16) aus elektrisch isolierendem Material, das jede Seele (15) an ihrem Umfang bedeckt, dann die Herstellung von Hüllen (17) aus unterschiedlichen Metallen oder einem anderen halbleitenden Material, die die anderen Arme der Nanodrähte bilden, wobei eine elektrische Verbindung (18, 26, 27) aus elektrisch leitendem Material die Seele (15) und die Hülle (17) jedes Nanodrahts an seinem freien Ende individuell verbindet.

15. Verfahren nach Anspruch 14, **dadurch gekennzeichnet, dass**, auf die Seele (15) jedes Nanodrahts am Ende des Wachstumsschritts ein Tröpfchen (18) aus elektrisch leitendem Material steht, das während des Wachstumsschritts als Katalysator gedient hat, wobei dieses Katalysatortröpfchen (18) die elektrische Verbindung zwischen der Seele und der Hülle des Nanodrahts bildet.

16. Verfahren nach einem der Ansprüche 8 bis 15, **dadurch gekennzeichnet, dass** die Schicht (16) aus elektrisch isolierendem Material durch Oxidation der Arme gebildet wird, die sie an deren Umfang bedeckt.
